# EUROPEAN PATENT APPLICATION

(11) **EP 3 316 462 A1**
(43) Date of publication of application: **02.05.2018**
(21) Application number: 17198833.0
(22) Date of filing: 27.10.2017
(51) Int. Cl.: H02M 1/32, H02M 3/158, H02H 7/12, H02M 3/155, G01R 31/40, H02H 9/02

(54) **APPARATUS AND METHOD FOR DETECTING CONVERTER FAILURE**

(30) Priority: 31.10.2016 KR 20160142969
(71) Applicant: LS Automotive Corp, 15611 (KR)
(72) Inventor: JANG, Min-gyu, 17057 Gyeonggi-do (KR)
(74) Representative: Zimmermann, Tankred Klaus

(57) **Abstract**

Disclosed herein are an apparatus and method for detecting converter failure, capable of determining whether or not a DC-DC converter fails by comparing high and low voltages of the converter with a voltage at each node. The apparatus includes a first power supply for supplying a first voltage, a first switch unit including first and second semiconductor devices, a second power supply for supplying a second voltage, a second switch unit including third and fourth semiconductor devices, a converter connected to the first and second switch units for increasing or decreasing the first voltage based on a PWM signal, a first capacitor connected to a first node, a second capacitor connected to a second node, and a determination unit configured to detect the first and second voltages and voltages at the first and second nodes to determine whether or not the semiconductor devices fail.

## Description

### CROSS-REFERENCE(S) TO RELATED APPLICATIONS

This application claims priority to Korean Patent Application No. 10-2016-0142969, filed on October 31, 2016, the disclosure of which is incorporated herein by reference in its entirety.

### BACKGROUND OF THE INVENTION

### Field of the Invention

Exemplary embodiments of the present invention relate to an apparatus and method for detecting converter failure, and more particularly, to an apparatus and method for detecting converter failure, capable of determining whether or not a DC-DC converter fails by comparing high and low voltages of the converter with a voltage at each node.

### Description of the Related Art

With the popularization of 48V converter systems for vehicles in recent years, the need for bi-direction DC-DC converters arises to control a flow of electricity in existing 12V converter systems and 48V converter systems.

If a DC-DC converter is operated for a long time or electric energy converted by the same is excessively increased, the DC-DC converter may break down due to overheating of a plurality switches arranged in the DC-DC converter.

When a second switch of the DC-DC converter is turned on in a state in which a first switch of the DC-DC converter is shorted due to failure, the failure of the DC-DC converter may be magnified by the short-circuit of the first switch.

It is possible to check a degree of change in temperature of the entire DC-DC converter, but it is impossible to specify a broken switch or a heating position from among the switches included in the DC-DC converter. Hence, it is difficult to detect the failure of the DC-DC converter.

### [Related Art Document]

### [Patent Document]

(Patent Document) Korean Patent No. 10-0836313 (June 02, 2008)

### SUMMARY OF THE INVENTION

An object of the present invention is to provide an apparatus and method for detecting converter failure, capable of separately detecting failures of individual switches arranged in a converter.

Another object of the present invention is to provide an apparatus and method for detecting converter failure, capable of achieving a reduction in time and cost by increasing a determination rate of switch failure.

A further object of the present invention is to provide an apparatus and method for detecting converter failure, capable of reducing a detection error in switch failure caused by a voltage charged in a capacitor disposed in a converter.

Other objects and advantages of the present invention can be understood by the following description, and become apparent with reference to the embodiments of the present invention. Also, it is obvious to those skilled in the art to which the present invention pertains that the objects and advantages of the present invention can be realized by the means as claimed and combinations thereof.

In accordance with one aspect of the present invention, an apparatus for detecting converter failure includes a first power supply for supplying a first voltage, a first switch unit connected to the first power supply and including a first semiconductor device and a second semiconductor device, a second power supply for supplying a second voltage, a second switch unit connected to the second power supply and including a third semiconductor device and a fourth semiconductor device, a converter connected to the first and second switch units, and turned on or off based on a pulse width modulation (PWM) signal, for increasing or decreasing the first voltage based on the PWM signal, a first capacitor connected to a first node that connects the first switch unit to the converter, a second capacitor connected to a second node that connects the second switch unit to the converter, and a determination unit configured to detect the first and second voltages and voltages at the first and second nodes to determine whether or not at least one of the first to fourth semiconductor devices fails.

The first and second switch units may be turned off, and the determination unit may detect the first voltage and the voltage at the first node and compare them when the converter is turned off, in order to determine that the first semiconductor device fails when the first voltage is less than the voltage at the first node.

The first switch unit may be turned off whereas the second switch unit may be turned on, and the determination unit may detect the first voltage and the voltage at the first node and compare them when the converter increases the first voltage, in order to determine that the second semiconductor device fails when the first voltage is equal to or greater than the voltage at the first node.

The first and second switch units may be turned off, and the determination unit may detect the second voltage and the voltage at the second node and compare them when the converter is turned off, in order to determine that the third semiconductor device fails when the second voltage is less than the voltage at the second node.

The first switch unit may be turned on whereas the second switch unit may be turned off, and the determination unit may detect the second voltage and the voltage at the second node and compare them when the converter decreases the first voltage, in order to determine that the fourth semiconductor device fails when the second voltage is equal to or greater than the voltage at the second node.

In accordance with another aspect of the present invention, a method of detecting converter failure is performed for the apparatus for detecting converter failure, and includes determining whether or not the first and second semiconductor devices fail by comparing the first voltage with the voltage at the first node, and determining whether or not the third and fourth semiconductor devices fail by comparing the second voltage with the voltage at the second node.

The determining whether or not the first and second semiconductor devices fail may include, in a state in which the first and second switch units and the converter are turned off, detecting the first voltage and the voltage at the first node and comparing them, in order to determine that the first semiconductor device fails when the first voltage is less than the voltage at the first node.

The determining whether or not the first and second semiconductor devices fail may include, in a state in which the first switch unit is turned off while the second switch unit is turned on and the converter increases the first voltage, detecting the first voltage and the voltage at the first node and comparing them, in order to determine that the second semiconductor device fails when the first voltage is equal to or greater than the voltage at the first node.

The determining whether or not the third and fourth semiconductor devices fail may include, in a state in which the first and second switch units and the converter are turned off, detecting the second voltage and the voltage at the second node and comparing them, in order to determine that the third semiconductor device fails when the second voltage is less than the voltage at the second node.

The determining whether or not the third and fourth semiconductor devices fail may include, in a state in which the first switch unit is turned on while the second switch unit is turned off and the converter decreases the first voltage, detecting the second voltage and the voltage at the second node and comparing them, in order to determine that the fourth semiconductor device fails when the second voltage is equal to or greater than the voltage at the second node.

It is to be understood that both the foregoing general description and the following detailed description of the present invention are exemplary and explanatory and are intended to provide further explanation of the invention as claimed.

### BRIEF DESCRIPTION OF THE DRAWINGS

The above and other objects, features and other advantages of the present invention will be more clearly understood from the following detailed description taken in conjunction with the accompanying drawings, in which:
Fig. 1 is a circuit diagram illustrating a configuration of an apparatus for detecting converter failure according to an embodiment of the present invention;
Fig. 2A and Fig. 2B are a diagram illustrating a current flow according to whether or not a first semiconductor device fails;
Fig. 3 is a flowchart illustrating a method of detecting a failure of a first semiconductor device;
Fig. 4A and Fig. 4B are a diagram illustrating a current flow according to whether or not a second semiconductor device fails;
Fig. 5 is a flowchart illustrating a method of detecting a failure of a second semiconductor device;
Fig. 6A and Fig. 6B are a diagram illustrating a current flow according to whether or not a third semiconductor device fails;
Fig. 7 is a flowchart illustrating a method of detecting a failure of a third semiconductor device;
Fig. 8A and Fig. 8B is a diagram illustrating a current flow according to whether or not a fourth semiconductor device fails; and
Fig. 9 is a flowchart illustrating a method of detecting a failure of a fourth semiconductor device.

### DESCRIPTION OF SPECIFIC EMBODIMENTS

Exemplary embodiments of the present invention will be described below in more detail with reference to the accompanying drawings so as to be realized by a person of ordinary skill in the art. The present invention may, however, be embodied in different forms and should not be construed as limited to the embodiments set forth herein.

In certain embodiments, description irrelevant to the present invention may be omitted to avoid obscuring appreciation of the disclosure. Throughout the disclosure, like reference numerals refer to like parts throughout the various figures and embodiments of the present invention.

In the whole description, it will be understood that when an element is referred to as being "connected" to another element, it can be "directly connected" to the other element or it can be "electrically connected" to the other element with other elements being interposed therebetween. In addition, it will be understood that when a component is referred to as being "comprising" any component, it does not exclude other components, but can further comprises the other components unless otherwise specified.

It will be understood that when an element is referred to as being "above" another element, it can be immediately above the other element or intervening elements may also be present. In contrast, when an element is referred to as being "immediately above" another element, there are no intervening elements present.

Although terms such as first, second, and third are used to describe various parts, components, regions, layers, and/or sections, the present invention is not limited thereto. Such terms will be used only to differentiate one part, component, region, layer, or section from other parts, components, regions, layers, or sections. Accordingly, a first part, component, region, layer, or section may be referred to as a second part, component, region, layer, or section without deviating from the scope and spirit of the present invention.

The terminology used in the specification of the present invention is for the purpose of describing particular embodiments only and is not intended to limit the invention. As used in the specification and the appended claims, the singular forms are intended to include the plural forms as well, unless context clearly indicates otherwise. It will be further understood that the terms "comprises" and/or "comprising," when used in this specification, specify the presence of stated features, regions, integers, steps, operations, elements, and/or components, but do not preclude the presence or addition of one or more other features, regions, integers, steps, operations, elements, and/or components thereof.

Spatially-relative terms such as "below", "above", or the like may be used herein to describe one element's relationship to another element as illustrated in the Figures. It will be understood that spatially-relative terms are intended to encompass different orientations of the device in addition to the orientation depicted in the Figures. For example, if the device in one of the figures is turned over, elements described as "below" other elements would then be oriented "above" the other elements. The exemplary terms "below" can, therefore, encompass both an orientation of above and below. Since the device may be oriented in another direction such as rotation of 90° or another angle, the spatially-relative terms may be interpreted in accordance with the orientation of the device.

Unless otherwise defined, all terms, including technical and scientific terms, used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Hereinafter, exemplary embodiments of the present invention will be described in more detail with reference to the accompanying drawings so as to be realized by a person of ordinary skill in the art. The present invention may, however, be embodied in different forms and should not be construed as limited to the embodiments set forth herein.

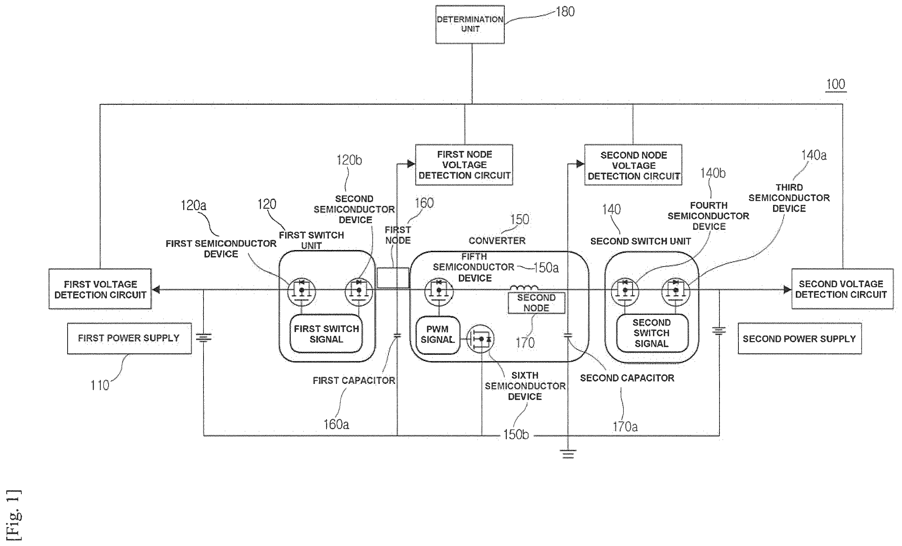

Fig. 1 is a circuit diagram illustrating a configuration of an apparatus for detecting converter failure according to an embodiment of the present invention.

Referring to Fig. 1, the apparatus for detecting converter failure, which is designated by reference numeral 100, according to the embodiment of the present invention includes a first power supply 110, a first switch unit 120, a second power supply 130, a second switch unit 140, a converter 150, a first capacitor 160a, a second capacitor 170a, and a determination unit 180.

A positive (+) terminal of the first power supply 110 is connected to the first switch unit 120, and a negative (-) terminal of the first power supply 110 is connected to the ground.

The first switch unit 120 includes a first semiconductor device 120a and a second semiconductor device 120b, and is connected to the first power supply 110 and the converter 150. Gate terminals of the first and second semiconductor devices 120a and 120b are connected to an input terminal for a first switch signal, and source terminals of the first and second semiconductor devices 120a and 120b are connected to each other. A drain terminal of the first semiconductor device 120a is connected to the first power supply 110, and a drain terminal of the second semiconductor device 120b is connected to the converter 150.

The first capacitor 160a is connected to a first node 160 that connects the first power supply 110 to the converter 150. A first electrode (for instance, a positive electrode) of the first capacitor 160a is connected to the first node 160, and a second electrode (for instance, a negative electrode) of the first capacitor 160a is connected to the ground.

Meanwhile, a positive (+) terminal of the second power supply 130 is connected to the second switch unit 140, and a negative (-) terminal of the second power supply 130 is connected to the ground.

The second switch unit 140 includes a third semiconductor device 140a and a fourth semiconductor device 140b, and is connected to the second power supply 130 and the converter 150. Gate terminals of the third and fourth semiconductor devices 140a and 140b are connected to an input terminal for a second switch signal, and source terminals of the third and fourth semiconductor devices 140a and 140b are connected to each other. A drain terminal of the third semiconductor device 140a is connected to the second power supply 130, and a drain terminal of the fourth semiconductor device 140b is connected to the converter 150.

The second capacitor 170a is connected to a second node 170 that connects the second switch unit 140 to the converter 150. A first electrode (for instance, a positive electrode) of the second capacitor 170a is connected to the second node 170, and a second electrode (for instance, a negative electrode) of the second capacitor 170a is connected to the ground.

The converter 150 includes a fifth semiconductor device 150a and a sixth semiconductor device 150b, and is connected to the first and second switch units 120 and 140. Gate terminals of the fifth and sixth semiconductor devices 150a and 150b are connected to an input terminal for a pulse width modulation (PWM) signal. A source terminal of the fifth semiconductor 150a is connected to a drain terminal of the sixth semiconductor device 150b so that the fifth and sixth semiconductor devices 150a and 150b are interconnected in series. The source terminal of the fifth semiconductor 150a and the drain terminal of the sixth semiconductor device 150b are connected to the second node. A drain terminal of the fifth semiconductor device 150a is connected to the first node 160, and a source terminal of the sixth semiconductor device 150b is connected to the ground.

The configuration of the apparatus for detecting converter failure according to the embodiment of the present invention will be described below with reference to circuit diagrams. The first power supply 110 supplies a first voltage to charge the first capacitor 160a. In detail, the first power supply 110 is a power source that supplies a high voltage, and supplies a first voltage of 48 V to the first capacitor 160a.

The first switch unit 120 is turned on or off to switch the supply of the first voltage to the first capacitor 160a.

The first semiconductor device 120a is included in the first switch unit 120, and may switch a current flow depending on the arrangement direction thereof. The first semiconductor device 120a may include a transistor, a MOSFET, an insulated-gate bipolar transistor (IGBT), and the like.

When the first switch signal is input to the first semiconductor device 120a, the first semiconductor device 120a is turned on, whereas when first switch signal is not input to the first semiconductor device 120a, the first semiconductor device 120a is turned off.

The second semiconductor device 120b is included in the converter, and may switch a current flow depending on the arrangement direction thereof. The second semiconductor device 120b may include a transistor, a MOSFET, an IGBT, and the like.

When the first switch signal is input to the second semiconductor device 120b, the second semiconductor device 120b is turned on, whereas when the first switch signal is not input to the second semiconductor device 120b, the second semiconductor device 120b is turned off.

Accordingly, the first switch unit 120 is turned on when the first switch signal is input thereto, so as to allow the first voltage to be supplied to the first capacitor 160a. Thus, the first power supply 110 may supply the first voltage to the first capacitor 160a to charge the first capacitor 160a.

In addition, the first switch unit 120 is turned off when the first switch signal is not input thereto, so as not to allow the first voltage to be supplied to the first capacitor 160a. Thus, the first power supply 110 may not supply the first voltage to the first capacitor 160a.

The second power supply 130 supplies a second voltage to charge the second capacitor 170a. In detail, the second power supply 130 is a power source that supplies a high voltage, and supplies a second voltage of 12 V or 48 V to the second capacitor 170a.

The second switch unit 140 is turned on or off to switch the supply of the second voltage to the second capacitor 170a.

The third semiconductor device 140a is included in the second switch unit 140, and may switch a current flow depending on the arrangement direction thereof. The third semiconductor device 140a may include a transistor, a MOSFET, an IGBT, and the like. In addition, when the second switch signal is input to the third semiconductor device 140a, the third semiconductor device 140a is turned on, whereas when the second switch signal is not input to the third semiconductor device 140a, the third semiconductor device 140a is turned off.

The fourth semiconductor device 140b is included in the converter, and may switch a current flow depending on the arrangement direction thereof. The fourth semiconductor device 140b may include a transistor, a MOSFET, an IGBT, and the like. In addition, when the second switch signal is input to the fourth semiconductor device 140b, the fourth semiconductor device 140b is turned on, whereas when the second switch signal is not input to the fourth semiconductor device 140b, the fourth semiconductor device 140b is turned off.

Accordingly, the second switch unit 140 is turned on when the second switch signal is input thereto, so as to allow the second voltage to be supplied to the second capacitor 170a. Thus, the second power supply 130 may supply the second voltage to the second capacitor 170a to charge the second capacitor 170a.

In addition, the second switch unit 140 is turned off when the second switch signal is not input thereto, so as not to allow the second voltage to be supplied to the second capacitor 170a. Thus, the second power supply 130 may not supply the second voltage to the second capacitor 170a.

The converter 150 is turned on or off based on the PWM signal, and increases or decreases the first voltage based on the PWM signal.

The fifth semiconductor device 150a is a semiconductor device included in the converter 150, and may switch a current flow depending on the arrangement direction thereof.

When the PWM signal is input to the fifth semiconductor device 150a, the fifth semiconductor device 150a is turned on, whereas when the PWM signal is not input to the fifth semiconductor device 150a, the fifth semiconductor device 150a is turned off.

The sixth semiconductor device 150b is a semiconductor device included in the converter, and may switch a current flow depending on the arrangement direction thereof.

When the PWM signal is input to the sixth semiconductor device 150b, the sixth semiconductor device 150b is turned on, whereas when the PWM signal is not input to the sixth semiconductor device 150b, the sixth semiconductor device 150b is turned off.

Accordingly, the converter 150 is turned on when the PWM signal is input thereto, and may increase or decrease the first voltage.

Here, the converter 150 may increase the first voltage when it is operated as a boost converter, and may decrease the first voltage when it is operated a buck converter. When the PWM signal is not input to the converter 150, the fifth and sixth semiconductor devices 150a and 150b are turned off to stop the operation of the converter 150.

The first capacitor 160a may be connected to the first node 160 such that the first voltage is supplied to the first capacitor 160a.

In addition, the second capacitor 170a may be connected to the second node 170 such that the second voltage is supplied to the second capacitor 170a.

The determination unit 180 detects the first voltage, the second voltage, a voltage at the first node, and a voltage at the second node to determine failures of the first, second, third, and fourth semiconductor devices 120a, 120b, 140a, and 140b.

In this case, the apparatus may include a detection circuit for detecting the first voltage, the second voltage, the voltage at the first node, and the voltage at the second node. The detection circuit may be embodied as separate detection circuits to individually the first voltage, the second voltage, the voltage at the first node, and the voltage at the second node, or may be embodied as a single detection circuit.

In detail, the determination unit 180 detects the first voltage and the voltage at the first node 160 and compares the first voltage with the voltage at the first node 160. In this case, the first switch unit 120 is turned off when the first switch signal is not input thereto, and the second switch unit 140 is also turned off when the second switch signal is not input thereto. In addition, the converter 150 is turned off when the PWM signal is not input thereto.

When the first voltage is less than the voltage at the first node 160 as a result of the comparison therebetween, the determination unit 180 determines that the first semiconductor device 120a fails.

On the other hand, when the first voltage is equal to or greater than the voltage at the first node 160 as a result of the comparison therebetween, the determination unit 180 determines that the first semiconductor device 120a does not fail.

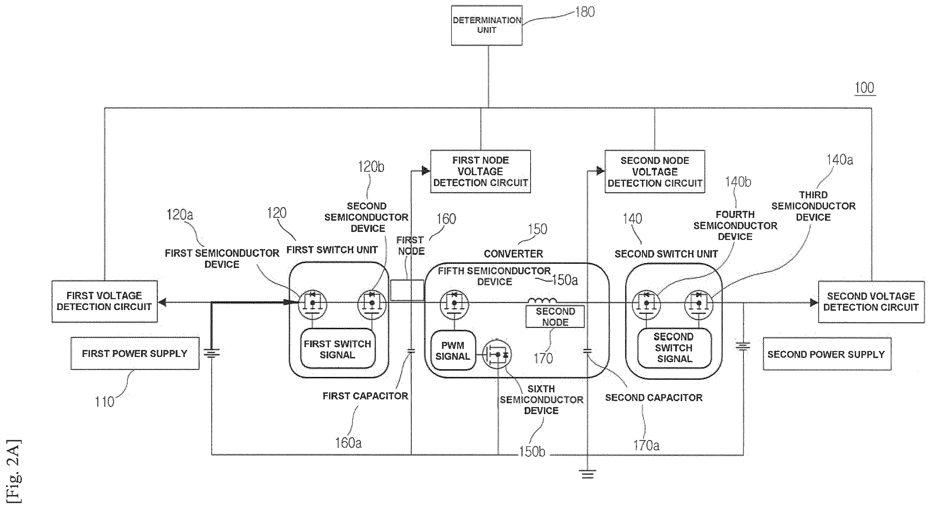

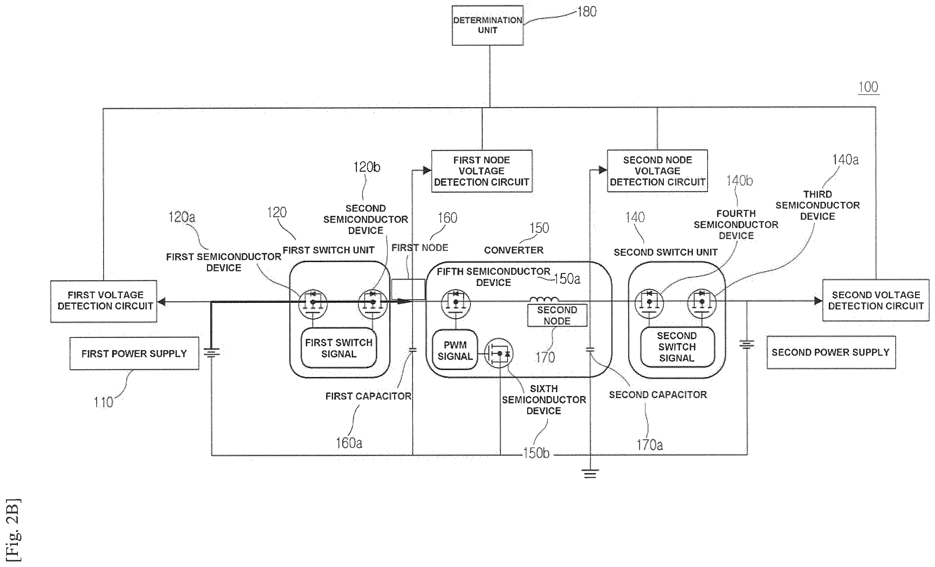

Fig. 2A and Fig. 2B are a diagram illustrating a current flow according to whether or not the first semiconductor device fails.

Referring to Figs. 2A and 2B, the first power supply 110 supplies the first voltage to the first capacitor 160a. Here, a first current flows from the first power supply 110 to the first capacitor 160a in order to supply the first voltage to the first capacitor 160a.

In this case, the first and second switch units 120 and 140 and the converter 150 are turned off. Thus, the first, second, third, fourth, fifth, and sixth semiconductor devices 120a, 120b, 140a, 140b, 150a, and 150b are turned off.

The first semiconductor device 120a is disposed in a direction opposite to the direction of the first current. The second semiconductor device 120b is disposed in the same direction as that of the first current.

Accordingly, when the first semiconductor device 120a does not fail, the first current does not flow to the first semiconductor device 120a, as in the current flow of Fig. 2A. Thus, the first current does not flow to the first node 160.

In this case, the first voltage is equal to or greater than the voltage at the first node 160 when the determination unit 180 detects and compares them. Therefore, the determination unit 180 may determine that the first semiconductor device 120a does not fail.

On the other hand, when the first semiconductor device 120a fails, the first current flows to the first semiconductor device 120a due to the failure of the first semiconductor device 120a, as in the current flow of Fig. 2B. In addition, since the second semiconductor device 120b is installed in the same direction as that of the first current, the first current flows to the second semiconductor device 120b. Thus, the first current flows to the first node 160. Consequently, the voltage at the first node 160 is equal to the first voltage.

In this case, the first voltage is less than the voltage at the first node 160 when the determination unit 180 detects and compares them. Therefore, the determination unit 180 may determine that the first semiconductor device 120a fails.

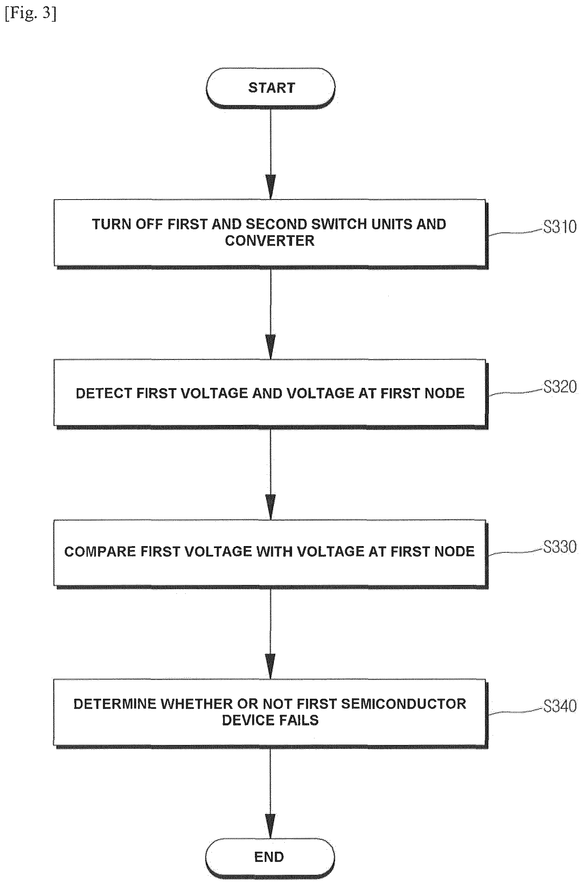

Fig. 3 is a flowchart illustrating a method of detecting the failure of the first semiconductor device.

Referring to Fig. 3, the first power supply 110 supplies the first voltage. In this case, the first and second switch units 120 and 140 and the converter 150 are turned off (S310).

Next, the determination unit 180 detects the first voltage and the voltage at the first node 160 (S320).

In detail, the determination unit 180 detects the first voltage supplied from the first power supply 110. In addition, the determination unit 180 detects the voltage at the first node 160 that connects the first switch unit 120 to the converter 150.

Next, the determination unit 180 compares the detected first voltage with the detected voltage at the first node 160 (S330).

In addition, the determination unit 180 determines whether or not the first semiconductor device 120a fails based on a result of the comparison between the first voltage and the voltage at the first node 160 (S340).

In detail, when the first voltage is less than the voltage at the first node 160 as a result of the comparison therebetween, the determination unit 180 determines that the first semiconductor device 120a fails.

On the other hand, when the first voltage is equal to or greater than the voltage at the first node 160 as a result of the comparison therebetween, the determination unit 180 determines that the first semiconductor device 120a does not fail.

In addition, when the converter 150 is operated as the boost converter, the determination unit 180 detects the first voltage and the voltage at the first node 160 and compares them.

Here, the converter 150 increases the first voltage when it is operated as the boost converter. In this case, the first switch unit 120 is turned off when the first switch signal is not input thereto, whereas the second switch unit 140 is turned on when the second switch signal is input thereto.

Next, when the first voltage is equal to or greater than the voltage at the first node 160 as a result of the comparison therebetween, the determination unit 180 determines that the second semiconductor device 120b fails.

On the other hand, when the first voltage is less than the voltage at the first node 160 as a result of the comparison therebetween, the determination unit 180 determines that the second semiconductor device 120b does not fail.

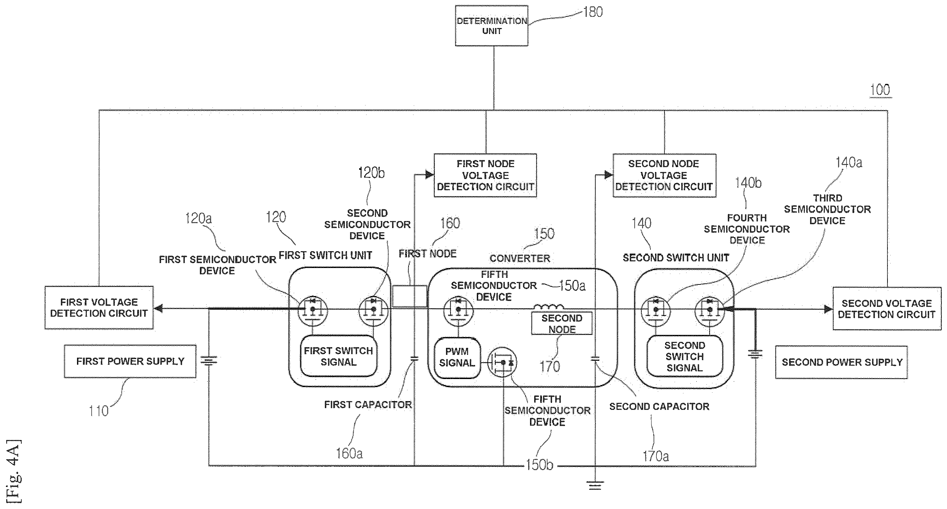

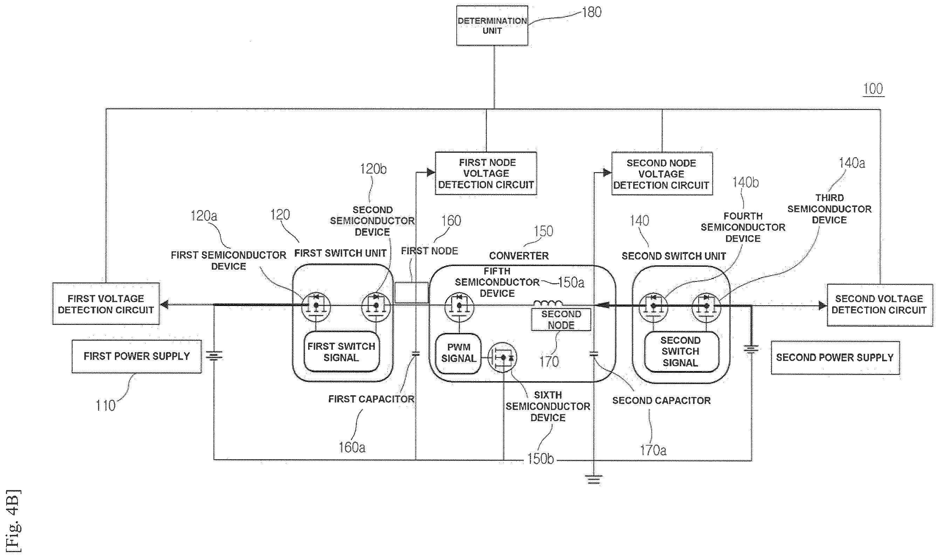

Fig. 4A and Fig. 4B are a diagram illustrating a current flow according to whether or not the second semiconductor device fails.

Referring to Figs. 4A and 4B, the converter 150 increases the first voltage based on the PWM signal. In this case, the first switch unit 120 is turned off whereas the second switch unit 140 is turned on.

Since the converter 150 is operated as the boost converter to increase the first voltage, the voltage at the first node 160 is equal to or greater than the first voltage. Accordingly, a second current flows from the first node 160 to the first power supply 110 in order to supply the voltage at the first node 160 to the first power supply 110. In this case, the determination unit 180 detects the first voltage and the voltage at the first node 160.

When the second semiconductor device 120b does not fail, the second current does not flow to the second semiconductor device 120b, as in the current flow of Fig. 4A.

In this case, the first voltage is less than the voltage at the first node 160 when the determination unit 180 detects and compares them. Therefore, the determination unit 180 may determine that the second semiconductor device 120b does not fail.

On the other hand, when the second semiconductor device 120b fails, the second current flows to the second semiconductor device 120b due to the failure of the second semiconductor device 120b, as in the current flow of Fig. 4B. Thus, the first voltage is equal to the voltage at the first node 160.

In this case, the first voltage is equal to or greater the voltage at the first node 160 when the determination unit 180 detects and compares them. Therefore, the determination unit 180 may determine that the second semiconductor device 120b fails.

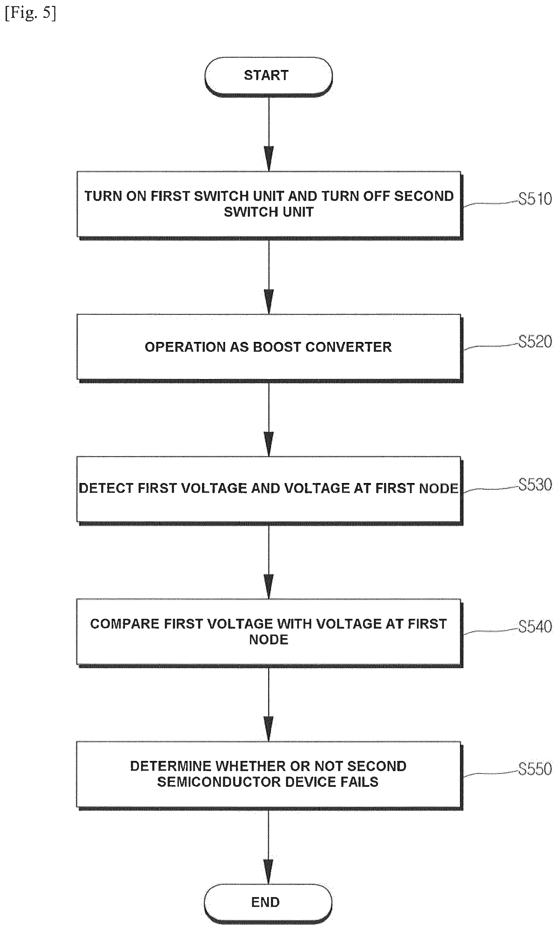

Fig. 5 is a flowchart illustrating a method of detecting the failure of the second semiconductor device.

Referring to Fig. 5, the first power supply 110 supplies the first voltage. In this case, the first switch unit 120 is turned off whereas the second switch unit 140 is turned on (S510).

Next, the converter 150 is operated as the boost converter based on the PWM signal (S520).

In detail, the converter 150 may increase the first voltage based on the PWM signal. Thus, the voltage at the first node 160 is equal to or greater than the first voltage.

Next, the determination unit 180 detects the first voltage and the voltage at the first node 160 (S530).

In detail, the determination unit 180 detects the first voltage supplied from the first power supply 110. In addition, the determination unit 180 detects the voltage at the first node 160 that connects the first switch unit 120 to the converter 150.

Next, the determination unit 180 compares the detected first voltage with the detected voltage at the first node 160 (S540).

In addition, the determination unit 180 determines whether or not the second semiconductor device 120b fails based on a result of the comparison between the first voltage and the voltage at the first node 160 (S550).

In detail, when the first voltage is equal to or greater than the voltage at the first node 160 as a result of the comparison therebetween, the determination unit 180 determines that the second semiconductor device 120b fails.

On the other hand, when the first voltage is less than the voltage at the first node 160 as a result of the comparison therebetween, the determination unit 180 determines that the second semiconductor device 120b does not fail.

In addition, the determination unit 180 detects the second voltage and the voltage at the second node 170 and compares them. In this case, the first switch unit 120 is turned off when the first switch signal is not input thereto, and the second switch unit 140 is also turned off when the second switch signal is not input thereto. In addition, the converter 150 is turned off when the PWM signal is not input thereto.

When the second voltage is less than the voltage at the second node 170 as a result of the comparison therebetween, the determination unit 180 determines that the third semiconductor device 140a fails.

On the other hand, when the second voltage is equal to or greater than the voltage at the second node 170 as a result of the comparison therebetween, the determination unit 180 determines that the third semiconductor device 140a does not fail.

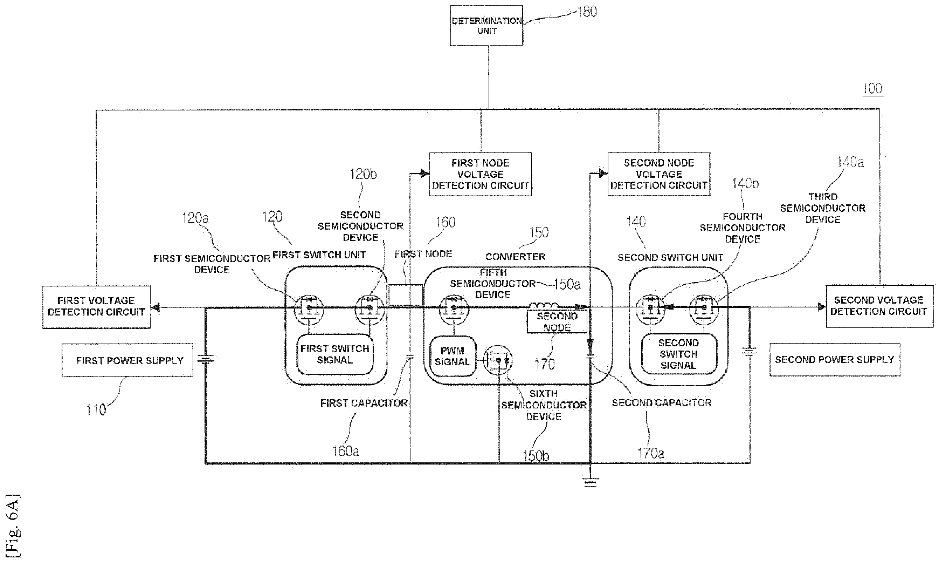

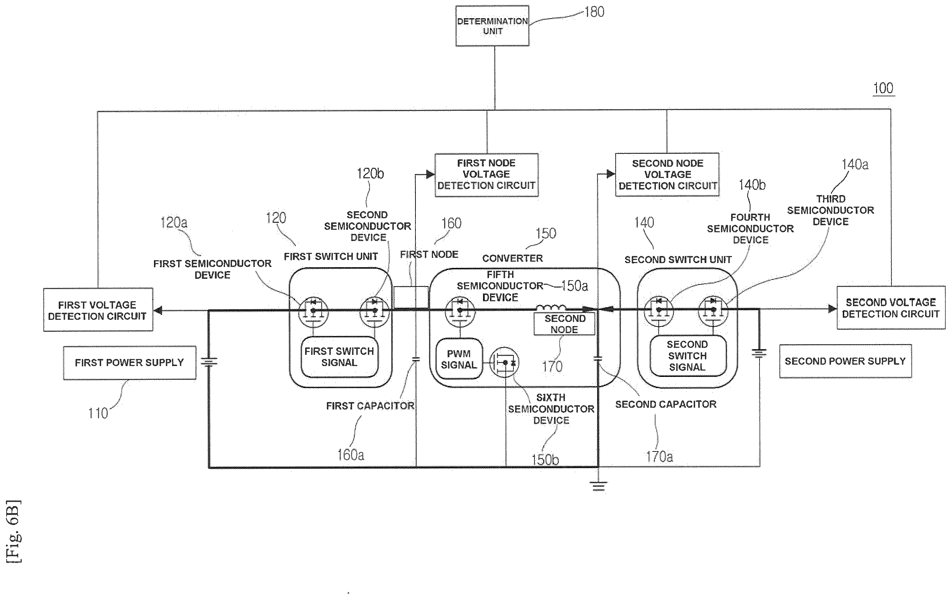

Fig. 6A and Fig. 6B are a diagram illustrating a current flow according to whether or not the third semiconductor device fails.

Referring to Figs. 6A and 6B, the second power supply 130 supplies the second voltage to the second capacitor 170a. Here, a third current flows from the second power supply 130 to the second capacitor 170a in order to supply the second voltage to the second capacitor 170a.

In this case, the first and second switch units 120 and 140 and the converter 150 are turned off. Thus, the first, second, third, fourth, fifth, and sixth semiconductor devices 120a, 120b, 140a, 140b, 150a, and 150b are turned off.

The third semiconductor device 140a is disposed in a direction opposite to the direction of the third current. The fourth semiconductor device 140b is disposed in the same direction as that of the third current.

Accordingly, when the third semiconductor device 140a does not fail, the third current does not flow to the third semiconductor device 140a, as in the current flow of Fig. 6A. Thus, the third current does not flow to the second node 170.

In this case, the second voltage is equal to or greater than the voltage at the second node 170 when the determination unit 180 detects and compares them. Therefore, the determination unit 180 may determine that the third semiconductor device 140a does not fail.

On the other hand, when the third semiconductor device 140a fails, the third current flows to the third semiconductor device 140a due to the failure of the third semiconductor device 140a, as in the current flow of Fig. 6B. In addition, since the fourth semiconductor device 140b is installed in the same direction as that of the third current, the third current flows to the fourth semiconductor device 140b. Thus, the third current flows to the second node 170. Consequently, the voltage at the second node 170 is equal to the second voltage.

In this case, the second voltage is less than the voltage at the second node 170 when the determination unit 180 detects and compares them. Therefore, the determination unit 180 may determine that the third semiconductor device 140a fails.

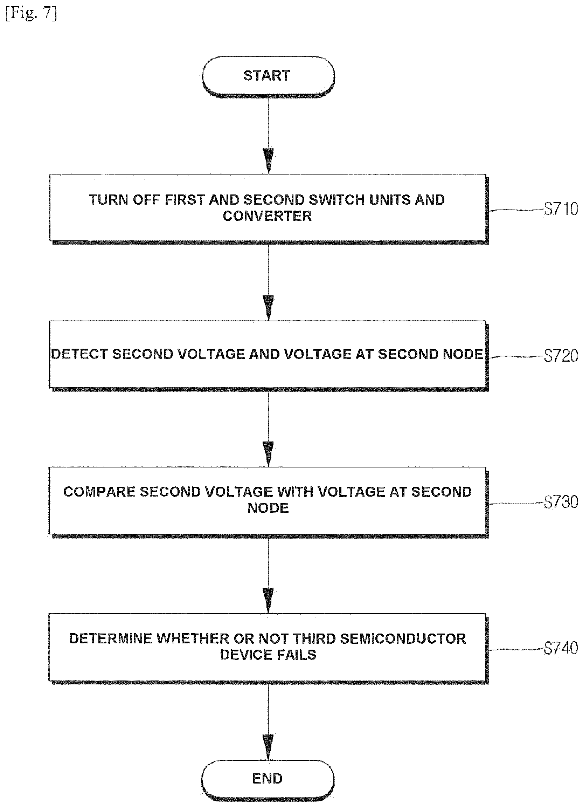

Fig. 7 is a flowchart illustrating a method of detecting the failure of the third semiconductor device.

Referring to Fig. 7, the second power supply 130 supplies the second voltage. In this case, the first and second switch units 120 and 140 and the converter 150 are turned off (S710).

Next, the determination unit 180 detects the second voltage and the voltage at the second node 170 (S720).

In detail, the determination unit 180 detects the second voltage supplied from the second power supply 130. In addition, the determination unit 180 detects the voltage at the second node 170 that connects the second switch unit 140 to the converter 150.

Next, the determination unit 180 compares the detected second voltage with the detected voltage at the second node 170 (S730).

In addition, the determination unit 180 determines whether or not the third semiconductor device 140a fails based on a result of the comparison between the second voltage and the voltage at the second node 170 (S740).

In detail, when the second voltage is less than the voltage at the second node 170 as a result of the comparison therebetween, the determination unit 180 determines that the third semiconductor device 140a fails.

On the other hand, when the second voltage is equal to or greater than the voltage at the second node 170 as a result of the comparison therebetween, the determination unit 180 determines that the third semiconductor device 140a does not fail.

In addition, when the converter 150 is operated as the buck converter, the determination unit 180 detects the second voltage and the voltage at the second node 170 and compares them.

Here, the converter 150 decreases the first voltage when it is operated as the buck converter. In this case, the first switch unit 120 is turned on when the first switch signal is input thereto, whereas the second switch unit 140 is turned off when the second switch signal is not input thereto.

Next, when the second voltage is equal to or greater than the voltage at the second node 170 as a result of the comparison therebetween, the determination unit 180 determines that the fourth semiconductor device 140b fails.

On the other hand, when the second voltage is less than the voltage at the second node 170 as a result of the comparison therebetween, the determination unit 180 determines that the fourth semiconductor device 140b does not fail.

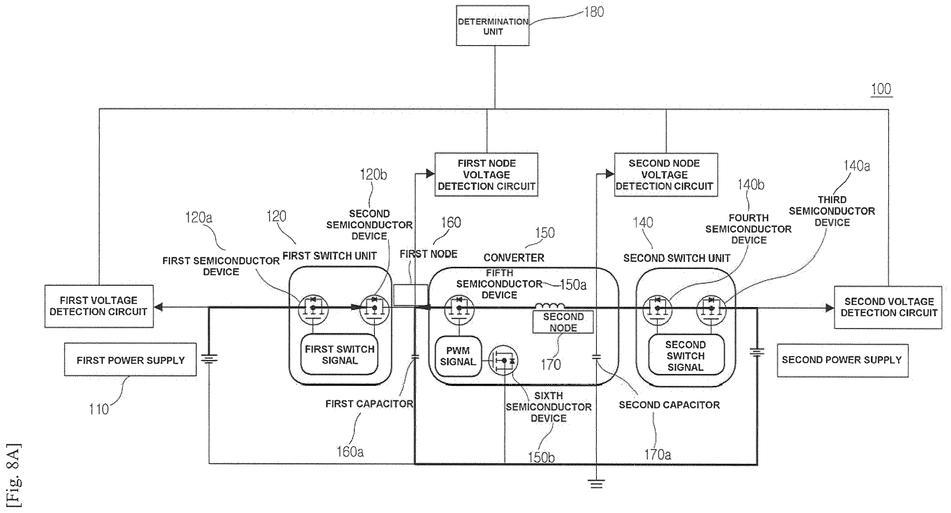

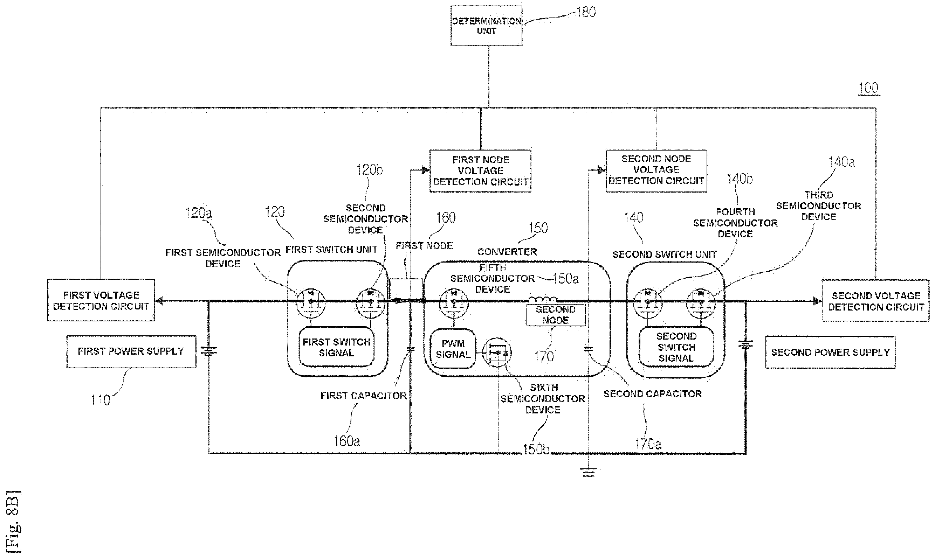

Fig. 8A and Fig. 8B are a diagram illustrating a current flow according to whether or not the fourth semiconductor device fails.

Referring to Figs. 8A and 8B, the converter 150 increases the second voltage based on the PWM signal. In this case, the first switch unit 120 is turned on whereas the second switch unit 140 is turned off.

Here, the converter 150 is operated as the buck converter to decrease the first voltage. In this case, the voltage at the second node 170 is equal to or greater than the second voltage while being less than the first voltage. Accordingly, a fourth current flows from the second node 170 to the second power supply 130 in order to supply the voltage at the second node 170 to the second power supply 130. In this case, the determination unit 180 detects the second voltage and the voltage at the second node 170.

When the fourth semiconductor device 140b does not fail, the fourth current does not flow to the fourth semiconductor device 140b, as in the current flow of Fig. 8A.

In this case, the second voltage is less than the voltage at the second node 170 when the determination unit 180 detects and compares them. Therefore, the determination unit 180 may determine that the fourth semiconductor device 140b does not fail.

On the other hand, when the fourth semiconductor device 140b fails, the fourth current flows to the fourth semiconductor device 140b due to the failure of the fourth semiconductor device 140b, as in the current flow of Fig. 8B. Thus, the second voltage is equal to the voltage at the second node 170.

In this case, the second voltage is equal to or greater the voltage at the second node 170 when the determination unit 180 detects and compares them. Therefore, the determination unit 180 may determine that the fourth semiconductor device 140b fails.

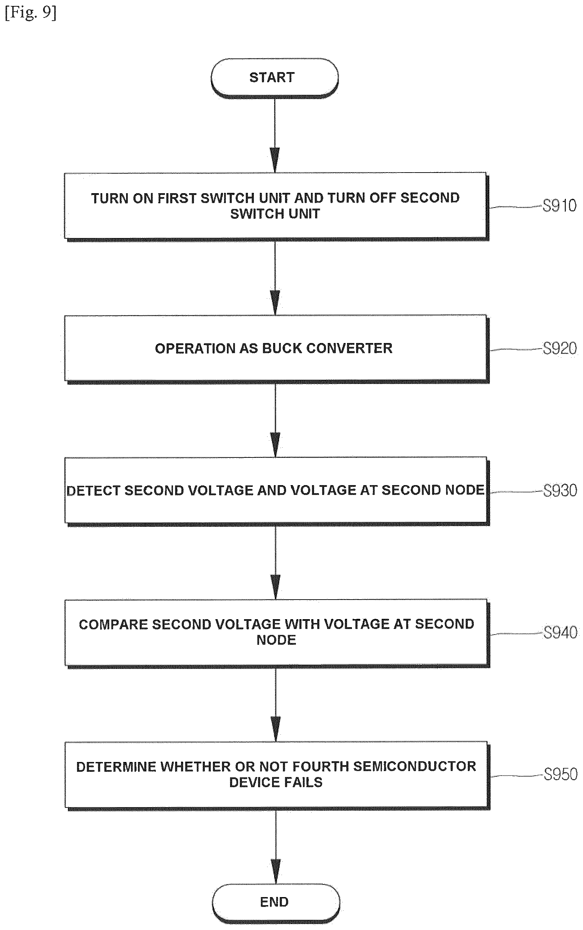

Fig. 9 is a flowchart illustrating a method of detecting the failure of the fourth semiconductor device.

Referring to Fig. 9, the second power supply 130 supplies the second voltage. In this case, the first switch unit 120 is turned on whereas the second switch unit 140 is turned off (S910).

Next, the converter 150 is operated as the buck converter based on the PWM signal (S920).

In detail, the converter 150 may decrease the first voltage based on the PWM signal. Thus, the voltage at the second node 170 is equal to or greater than the second voltage while being less than the first voltage.

Next, the determination unit 180 detects the second voltage and the voltage at the second node 170 (S930).

In detail, the determination unit 180 detects the second voltage supplied from the second power supply 130. In addition, the determination unit 180 detects the voltage at the second node 170 that connects the second switch unit 140 to the converter 150.

Next, the determination unit 180 compares the detected second voltage with the detected voltage at the second node 170 (S940).

In addition, the determination unit 180 determines whether or not the fourth semiconductor device 140b fails based on a result of the comparison between the second voltage and the voltage at the second node 170 (S950).

In detail, when the second voltage is equal to or greater than the voltage at the second node 170 as a result of the comparison therebetween, the determination unit 180 determines that the fourth semiconductor device 140b fails.

On the other hand, when the second voltage is less than the voltage at the second node 170 as a result of the comparison therebetween, the determination unit 180 determines that the fourth semiconductor device 140b does not fail.

As described above, the apparatus and method for detecting converter failure according to the embodiments of the present invention can determine whether or not the DC-DC converter fails by comparing the high and low voltages of the converter with the voltage at each node.

As is apparent from the above description, in accordance with an apparatus and method for detecting converter failure according to exemplary embodiments of the present invention, it is possible to detect failures of individual switches arranged in a converter and to determine a broken switch among them.

In addition, it is possible to achieve a reduction in time and cost by increasing a determination rate of switch failure.

Furthermore, it is possible to reduce a detection error in switch failure caused by the voltage charged in a capacitor that is disposed in the converter.

While the present invention has been particularly shown and described with reference to exemplary embodiments thereof, it will be understood by those skilled in the art that various changes in form and details may be made therein without departing from the spirit and scope of the invention as defined by the appended claims. The exemplary embodiments should be considered in descriptive sense only and not for purposes of limitation. Therefore, the scope of the invention is defined not by the detailed description of the invention but by the appended claims, and all differences within the scope will be construed as being included in the present invention.

## Claims

1. An apparatus for detecting converter failure, comprising:
a first power supply for supplying a first voltage;
a first switch unit connected to the first power supply and comprising a first semiconductor device and a second semiconductor device;
a second power supply for supplying a second voltage;
a second switch unit connected to the second power supply and comprising a third semiconductor device and a fourth semiconductor device;
a converter connected to the first and second switch units, and turned on or off based on a pulse width modulation (PWM) signal, for increasing or decreasing the first voltage based on the PWM signal;
a first capacitor connected to a first node that connects the first switch unit to the converter;
a second capacitor connected to a second node that connects the second switch unit to the converter; and
a determination unit configured to detect the first and second voltages and voltages at the first and second nodes to determine whether or not at least one of the first to fourth semiconductor devices fails.

2. The apparatus according to claim 1, wherein:
the first and second switch units are turned off; and
when the converter is turned off, the determination unit detects the first voltage and the voltage at the first node and compares the first voltage and voltage at the first node in order to determine that the first semiconductor device fails if the first voltage is less than the voltage at the first node.

3. The apparatus according to claim 1, wherein:
the first switch unit is turned off whereas the second switch unit is turned on; and
the determination unit detects the first voltage and the voltage at the first node and compares them when the converter increases the first voltage, in order to determine that the second semiconductor device fails when the first voltage is equal to or greater than the voltage at the first node.

4. The apparatus according to claim 1, wherein:
the first and second switch units are turned off; and
when the converter is turned off, the determination unit detects the second voltage and the voltage at the second node and compares the second voltage and the voltage at the second node in order to determine that the third semiconductor device fails if the second voltage is less than the voltage at the second node.

5. The apparatus according to claim 1, wherein:
the first switch unit is turned on whereas the second switch unit is turned off; and
when the converter decreases the first voltage, the determination unit detects the second voltage and the voltage at the second node and compares the second voltage and the voltage at the second node in order to determine that the fourth semiconductor device fails if the second voltage is equal to or greater than the voltage at the second node.

6. A method of detecting converter failure, the method being a failure detection method for the apparatus for detecting converter failure according to claim 1, comprising:
determining whether or not the first and second semiconductor devices fail by comparing the first voltage with the voltage at the first node; and
determining whether or not the third and fourth semiconductor devices fail by comparing the second voltage with the voltage at the second node.

7. The method according to claim 6, wherein the determining whether or not the first and second semiconductor devices fail comprises, in a state in which the first and second switch units and the converter are turned off, detecting the first voltage and the voltage at the first node and comparing the voltage at the first node, in order to determine that the first semiconductor device fails when the first voltage is less than the voltage at the first node.

8. The method according to claim 6, wherein the determining whether or not the first and second semiconductor devices fail comprises, in a state in which the first switch unit is turned off while the second switch unit is turned on and the converter increases the first voltage, detecting the first voltage and the voltage at the first node and comparing the first voltage and the voltage at the first node, in order to determine that the second semiconductor device fails when the first voltage is equal to or greater than the voltage at the first node.

9. The method according to claim 6, wherein the determining whether or not the third and fourth semiconductor devices fail comprises, in a state in which the first and second switch units and the converter are turned off, detecting the second voltage and the voltage at the second node and comparing the second voltage and the voltage at the second node, in order to determine that the third semiconductor device fails when the second voltage is less than the voltage at the second node.

10. The method according to claim 6, wherein the determining whether or not the third and fourth semiconductor devices fail comprises, in a state in which the first switch unit is turned on while the second switch unit is turned off and the converter decreases the first voltage, detecting the second voltage and the voltage at the second node and comparing the second voltage and the voltage at the second node, in order to determine that the fourth semiconductor device fails when the second voltage is equal to or greater than the voltage at the second node.
